# EUROPÄISCHE PATENTSCHRIFT

(11) **EP 0 463 472 B1**
(45) Veröffentlichungstag und Bekanntmachung des Hinweises auf die Patenterteilung: **07.02.1996**
(21) Anmeldenummer: 91109615.4
(22) Anmeldetag: 12.06.1991
(51) Int. Cl.: H03G 3/20, H04R 27/00

(54) **Elektronische Abschaltvorrichtung für ELA- oder Beschallungsanlagen**
Electronic muting circuit for electroacoustic systems or public address systems
Dispositif électronique d'interruption d'un système électroacoustique ou d'un système de sonorisation

(30) Priorität: 23.06.1990 DE 4020043
(43) Veröffentlichungstag der Anmeldung: 02.01.1992
(73) Patentinhaber: IGEDO Internationale Modemesse Kronen GmbH u. Co. Kommanditgesellschaft, D-40468 Düsseldorf (DE)
(72) Erfinder: Dyllong, Wolfgang, W-4050 Mönchengladbach 1 (DE)
(74) Vertreter: Stenger, Watzke & Ring Patentanwälte

(56) Entgegenhaltungen:
- EP-A- 0 298 046
- GB-A- 1 499 983
- NL-A- 8 900 099
- US-A- 4 887 298
- FUNKSCHAU, Nr. 10, Mai 1983, Seiten 47-52, München, DE, H. HÜLSHORST et al.: "Dem Lärm Grenzen gesetzt"

## Beschreibung

Die Erfindung betrifft eine Vorrichtung zum elektronischen Abschalten einer ELA- oder Beschallungsanlage bei Überschreiten eines vorgegebenen maximalen Lautstärkepegels, die in den die Audiosignale erzeugenden elektronischen Signalweg der Anlage geschaltet ist und eine Abschalteinrichtung aufweist, die zum Erkennen des Lautstärkepegels diesen aus der im Signalweg gemessenen Spannung ermittelt.

Ein Problem bei Beschallungsanlagen besteht darin, daß oft die Lautstärke zu hoch ist. Insbesondere bei Messen oder vergleichbaren Veranstaltungen, wo jedem Ausstellungsstand eine eigene Beschallungsanlage zugeordnet ist, mittels der die jeweiligen Aussteller beispielsweise Musik oder Informationen abspielen lassen können, kommt es sehr häufig vor, daß sich benachbarte Aussteller durch zu große Lautstärken ihrer Beschallungsanlagen gegenseitig stören.

Aus diesem Grunde ist die Verwendung einer elektronischen Abschaltvorrichtung für derartige ELA- oder Beschallungsanlagen bekannt (DE-GM 77 19 647). Dabei wird mittels eines Mikrofons der jeweilige Geräuschpegel ermittelt und bei Überschreiten eines bestimmten Wertes ein Relais zwischen dem Vor- und dem Endverstärker derart betätigt, daß die Anlage abgeschaltet wird. Nachteilig ist dabei, daß diese Lautstärkebegrenzungsvorrichtung sehr leicht manipulierbar ist, da das Mikrofon beispielsweise zur Geräuschdämpfung abgedeckt werden kann.

Ferner ist aus der DE-Zeitschrift "Funkschau", Nr. 10, Mai 1983, Seiten 47 bis 52 eine Vorrichtung bekannt, um den Schallpegel in Diskotheken zu begrenzen. Bei dieser Vorrichtung wird bei Überschreiten eines vorgegebenen maximalen Lautstärkepegels dieser mittels einer entsprechenden, regelnd in die NF-Signalübertragung eingreifende Elektronik begrenzt, indem die Verstärkung des NF-Signals in Abhängigkeit von dem Lautstärkepegel verringert wird. Diese bekannte Vorrichtung ist aber einerseits mit einem erheblichen Schaltungs- und Regelungsaufwand verbunden, um Klangverfälschungen zu vermeiden.

Davon ausgehend liegt der Erfindung die **Aufgabe** zugrunde, eine verbesserte Abschaltvorrichtung für ELA- oder Beschallungsanlagen bei Überschreiten eines vorgegebenen maximalen Lautstärkepegels zu schaffen, die mit geringem gerätetechnischem Aufwand realisierbar und bei extremen Signalformen, wie z.B. hohen Pegelspitzen, keine zusätzlichen und damit unerwünschten Abschaltungen der Anlage vornimmt.

Als technische **Lösung** wird mit der Erfindung vorgeschlagen, daß die Abschalteinrichtung zusätzlich über einen Signalkompressor zur Signalkompression zwischen Ein- und Ausgangssignal verfügt, und daß der Signalkompressor eine Regelung zur Einstellung der Konpressorfunktion enthält.

Eine nach dieser technischen Lehre ausgebildete elektronische Abschaltvorrichtung hat den Vorteil, daß sie durch ihre Einbindung des Signalkompressors in den Signalweg innerhalb der Anlage nicht mehr so leicht manipulierbar ist, da die Vorrichtung unmittelbar Einfluß auf die innerhalb der Anlage erzeugten Signale nimmt. Darüber hinaus ist die Abschaltvorrichtung durch die Integration in die Anlage äußeren Geräuschpegeleinflüssen entzogen, so daß die Abschaltvorrichtung sehr zuverlässig und vor allem reproduzierbar arbeitet.

Aufgrund der erfindungsgemäßen Ausgestaltung der Abschaltvorrichtung ist es möglich, nur bei echten Lautstärkepegel-Überschreitungen, nicht aber bei kurzzeitigem Auftreten extremer Signalformen, die Anlage durch die Abschalteinrichtung automatisch abzuschalten. Darüber hinaus hat die Abschaltvorrichtung den Vorteil, daß sie durch die eingebaute Regelung zur Kompression hohe Pegelspitzen reduziert.

Gemäß einer Weiterbildung der Vorrichtung weist die Abschalteinrichtung eine Regelung zur Einstellung der Kompression des Ein- und Ausgangssignals, eine Regelung zur Einstellung der Anstiegs- und Abfallzeit der Flanken des NF-Signals sowie eine Regelung zur Einstellung der Reaktionsschnelligkeit der Regelung zur Einstellung des Kompression auf.

Diese Vorrichtung ist bei ELA/PA-Anlage vorzugsweise zwischen die Vor- und Endstufe geschaltet. Alternativ hierzu ist die Vorrichtung zwischen Tape-Deck und Hi-Fi-Anlage geschaltet. Dadurch ist auf sehr optimale Weise eine sehr sichere Überprüfung des Lautstärkepegels möglich.

In einer weiteren, bevorzugten Weiterbildung der erfindungsgemäßen Vorrichtung wird eine elektronische Abschalteinrichtung vorgeschlagen, die bei extremer Pegelüberschreitung des maximal zulässigen Lautstärkepegels (NF-Pegel) das NF-Signal unterbricht und einen weiteren Betrieb der Anlage so lange verhindert, bis sich der gemessene NF-Pegel wieder im zulässigen Bereich befindet. Vorzugsweise beträgt dabei der Überschreitpegel ungefähr +3db über dem maximal zulässigen Lautstärkepegel. Dadurch ist auf technisch sehr einfache Weise realisiert, daß der maximal zulässige Lautstärkepegel nicht überschritten wird.

Eine weitere Weiterbildung der Erfindung schlägt einen Eingangsregler zun Einstellen der maximalen Eingangsempfindlichkeit der Vorrichtung vor. Der Spannungsregelbereich beträgt dabei vorzugsweise -20db bis +20db. Weiterhin ist vorzugsweise in einer weiteren Weiterbildung ein Ausgangsregler zum Einstellen des maximalen Ausgangspegels für die maximal zulässige Lautstärke vorgesehen, wobei der Spannungsregelbereich vorzugsweise ebenfalls -20db bis +20db beträgt. Mit diesem Ausgangsregler stellt man somit nach Einjustieren der optischen Anzeigeeinrichtung und Fixierung des Eingangspegels die maximal zulässige Lautstärke ein. Insgesamt ist dadurch die Möglichkeit gegeben, die Abschaltvorrichtung an jede professionelle oder semi-professionelle Anlage anzuschließen.

Das anliegende NF-Signal ist vorzugsweise in einem Bereich von 1:1 bis 10:1 zwischen Ein- und Ausgang komprimierbar. Mit diesem "Ratio-Regler" steht somit die Möglichkeit der Signal-Kompression offen. Der Kompressor nimmt dabei Einfluß auf Ein- und Ausgangssignale. Mit seinem extrem großen Regelbereich von 1:1 bis maximl 10:1 läßt sich somit das anliegende NF-Signal entsprechend zwischen Ein- und Ausgang komprimieren.

Weiterhin wird in einer Weiterbildung der erfindungsgemäßen Abschaltvorrichtung vorgeschlagen, daß das anliegende NF-Signal sowie die optische Anzeige einer Anzeigevorrichtung für den momentanen NF-Pegel in einem Bereich von ungefähr 20 msec bis 3 sec einstellbar ist. Dieser "Release-Regler" bestimmt somit die Anstiegs- und Abfallzeit des anliegenden NF-Signals. Er ist in Verbindung mit der optischen Anzeigeeinrichtung sowie dem nachfolgend noch zu beschreibenden Schalter der wichtigste Regler zur Einstellung der optischen Anzeigeeinrichtung sowie der Empfindlichkeit für Signalton und Signalabschaltung bei Überschreiten der maximal zulässigen Lautstärke. Mit seinem großen Regelbereich besteht die Möglichkeit, das NF-Signal sowie die optische Anzeige in einem Bereich von 20 msec bis 3 sec einzustellen. Dies ist für die exakte Einstellung wichtig. Dieser Regler bestimmt somit auch die Geschwindigkeit, in der die Abschaltvorrichtung den Signalton für das Erreichen der maximalen Lautstärke und das Abschalten des NF-Signals vornimmt.

Vor zugsweise ist der Einstellbereich des Reglers zur Einstellung der Reaktionsschnelligkeit 3-stufig mit den Stufen von ungefähr 0,3 msec, 3 msec, 7 msec ausgebildet. Dieser 3-Wege-Schalter bestimmt somit die sogenannte Attack-Time, d.h. die Schnelligkeit, mit der der Kompressor in der Limiter-Schaltung reagiert. Mit diesem Schalter lassen sich somit ebenfalls sehr schnelle Signalspitzen, die normalerweise ein sofortiges Abschalten durch Pegelüberschreitung zur Folge hätten, linearisieren.

In einer weiteren Weiterbildung der erfindungsgemäßen Abschaltvorrichtung wird vorgeschlagen, daß die Pegel bzw. Regler frei einstellbar sind. Dadurch ist eine individuelle Anpassung der Vorrichtung an die jeweiligen Gegebenheiten ohne weiteres möglich.

Schließlich wird in einer Weiterbildung vorgeschlagen, daß die Einstell- und Anschlußelemente der Vorrichtung in einem verschließbaren Gehäuse vor unbefugten Fremdeingriffen gesichert angeordnet sind. Dies bringt den Vorteil mit sich, daß Unbefugte die erfindungsgemäße Abschaltvorrichtung nicht für ihre Zwecke manipulieren können. Die Einstellung der Vorrichtung ist somit nur autorisierten Personen möglich.

Ein Ausführungsbeispiel einer erfindungsgemäßen elektronischen Abschaltvorrichtung wird nachfolgend anhand der Zeichnungen beschrieben. In diesen zeigt:

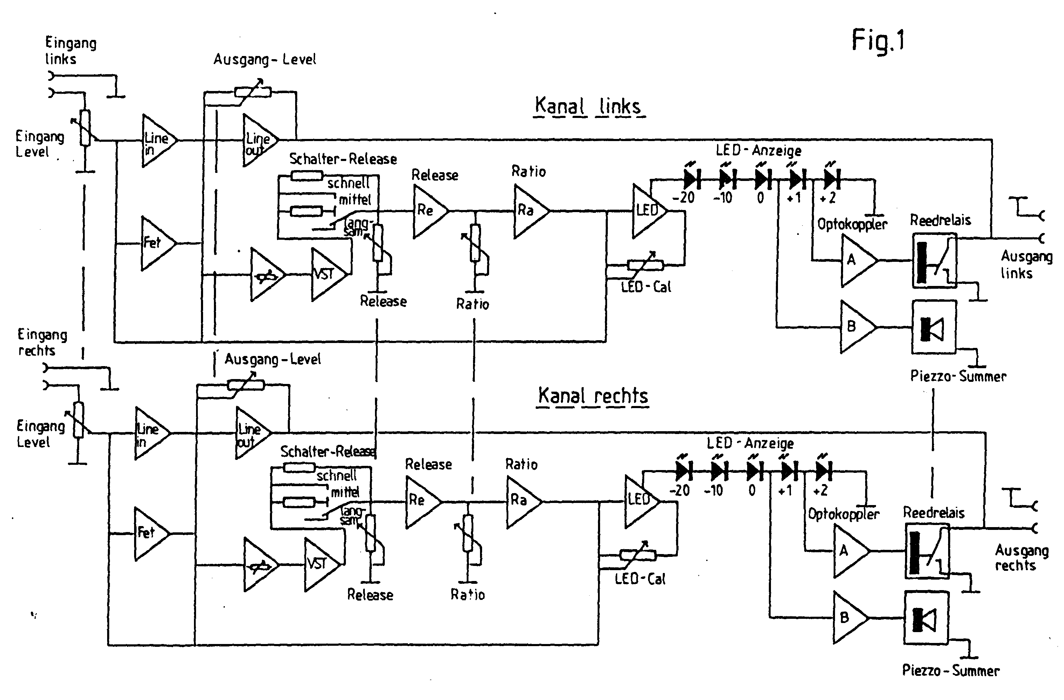

Fig. 1 ein Funktionsschaltbild der Vorrichtung;

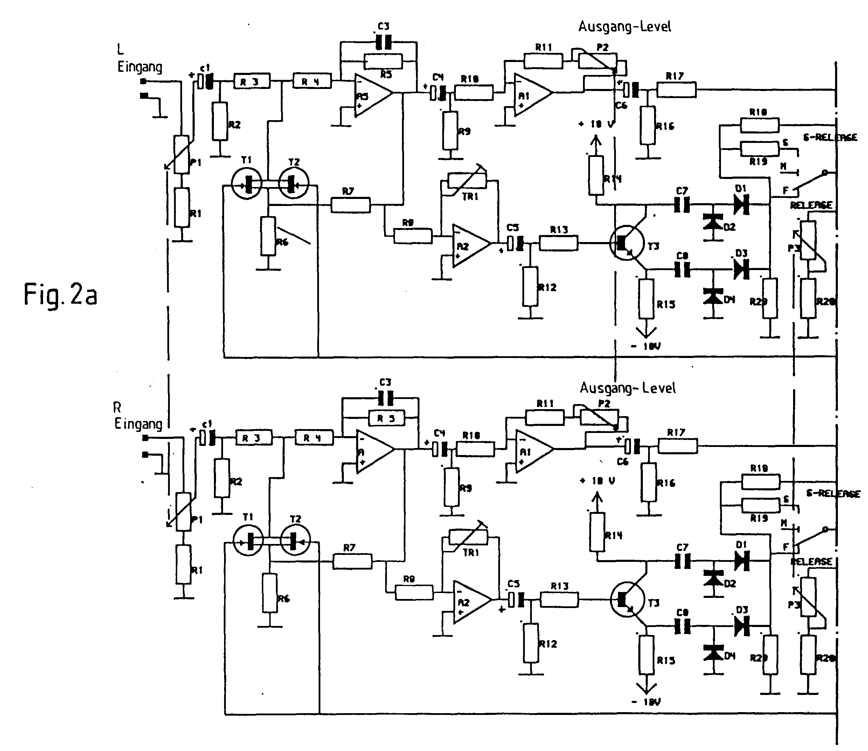

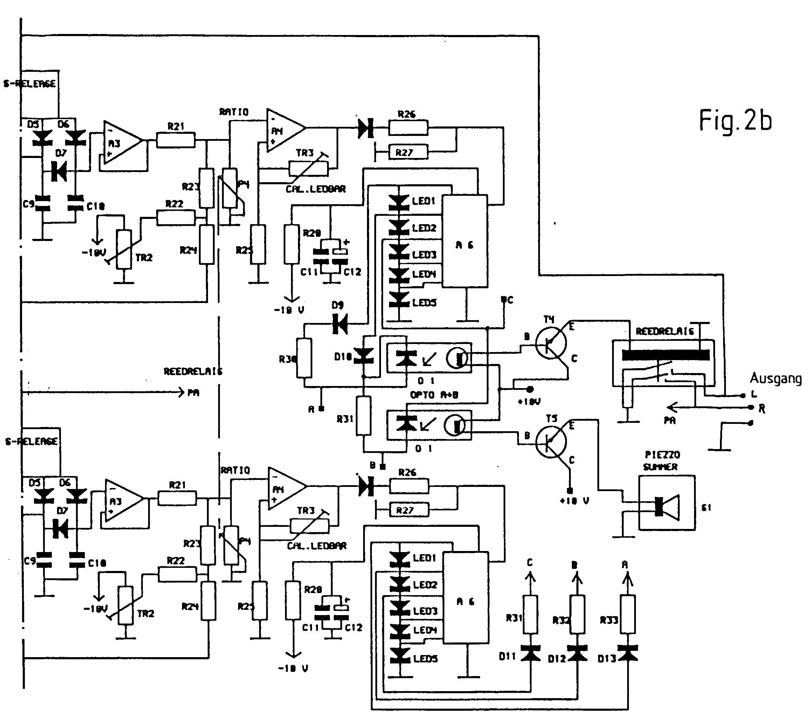

Fig. 2 den zugehörigen Schaltplan der Vorrichtung.

Das am Eingang anliegende NF-Signal wird über einen Input-Regler P1, Kondensator C1, Widerstand R3 und R4 einem Vorverstärker IC A5 zugeführt. Am Ausgang des Eingangsverstärkers von IC A5 wird das Signal über einen Kondensator C4 und einen Widerstand R10 einem Ausgangsverstärker IC A1 zugeführt. Mit einem Regler P2 des IC's A1 wird der Ausgangspegel definiert und über einen Kondensator C6 mit Widerstand R17 wird das anliegende Signal direkt der Ausgangsbuchse zugeführt. Die maximale Eingangs- und Ausgangsverstärkung beträgt hierbei jeweils 40db, d.h ein Spannungsregelbereich, für den Eingangsregler von -20db bis +20db und für den Ausgangsregler von -20db bis +20db. Eine "sound"-unbeeinflußte Wiedergabe des am Eingang anliegenden Signals ist somit möglich.

Der Lautstärkebegrenzer ist weiterhin mit einer Kompressor-Limiter-Schaltung ausgerüstet. Diese wird zwischen den Widerständen R3 und R4 angesteuert. Das NF-Signal wird über zwei Fet-Transistoren T1 und T2 Widerständen R7 und R8 einem IC A2 zugeführt. Parallel zu diesem IC A2 ist ein Trimmer TR1 geschaltet, der zur Kalibrierung der "Threshold"-Funktion bestimmt ist. Das Ausgangssignal von IC A2 führt weiter über einen Transistor T3 zum Schalter "Release". Mit diesem 3-Stufenschalter besteht die Möglichkeit, die Signal-"Attack"-Zeit in drei festgelegten Zeiten einzustellen (fast 300 µsec, middle 3 msec, slow 7 msec).

Nach dem Schalter "Release" wird das NF-Signal dem IC A3 zugeführt. Der in der Schaltung dem IC A3 über D1 zugeführte Regler "Release Time" regelt die Signalanstiegs- und Abfallzeit des NF-Signals in einem Regelbereich von 20 msec bis 3 sec in Verbindung mit IC A3. Weiterhin wird noch mit einem Trimmer TR2 über Widerstände R22, R23, R21 zum IC A3 und A4 sowie über einen Widerstand R24 zum Fet-Transistor T1 und T2 die "Bias"-Kalibrierung ermöglicht und das NF-Signal rückgekoppelt. Mit dem Regler P4 "Ratio control" wird zum IC A3 - A4 die Kompression des Signals eingestellt. Der Regelbereich der "Ration control" beträgt 1:1 bis maximal 10:1.

Über IC A4 mit Diode D8 und Widerstand R26 wird das Signal dem Meßbereich der Schaltung zugeführt. Der Trimmer TR3 parallel zu IC A4 sorgt für die Kalibrierung der LED-Anzeige.

Der LED-Treiber IC A6 treibt die "LED-Segment-Anzeige" an. Die LED-Anzeige besteht aus zwei grünen LED's (LED5 Bereich ab -10db, LED4 Bereich ab -3db), einer gelben LED (LED3 Bereich ab Odb) und zwei roten LED's (LED2 Bereich +1db, LED1 Bereich +3db).

Die LED's 3,4 und 5 sind für jeden Kanal getrennt zur Überwachung des maximalen Pegels der anliegenden NF-Signale bestimmt. Wird durch Überpegel des Signals die erste rote LED (LED2) vom LED-Treiber IC A6 angesprochen, so wird die anliegende Spannung über eine Diode D18 an einen Optokoppler 01 weitergeleitet. Der Optokoppler 01 wird leitend und steuert den Transistor T5 an. Dieser schaltet die anliegende Spannung von 18V auf einen Piezzosummer SU1, der einen "Signal-Warnton" in der gleichen Länge und Zeit, wie der LED-Treiber die LED2 ansteuert, abgibt.

Sollte darüber hinaus der Signalpegel weiter erhöht werden, schaltet der LED-Treiber IC A6 zum LED-Segment 1 durch ("0ut-Warn-LED") und der Optokoppler 02 wird angesteuert. Transistor T4 schaltet die anliegende Spannung von 18V auf das IC Reedrelais RA1. Dieses zieht an und schließt über seine beiden Kontakte, die einseitig an Masse liegen, die Ausgänge der Schaltung gegen Massepotential kurz. Das am Eingang anliegende NF-Signal wird, solange die LED1 durch Überpegel angesprochen wird, abgeschaltet. Wird nun der Eingangspegel abgesenkt, nimmt der Lautstärkebegrenzer den normalen Betrieb sofort wieder auf. Das am Eingang anliegende NF-Signal wird sofort wieder am Ausgang der Schaltung freigegeben. Auch ertönt bei Abschaltung des NF-Signals konstant der Piezzosummer, da die LED-Segmentanzeige in Abhängigkeit voneinander angesteuert wird.

## Patentansprüche

1. Vorrichtung zum elektronischen Abschalten einer ELA- oder Beschallungsanlage bei Überschreiten eines vorgegebenen maximalen Lautstärkepegels, die in den die Audiosignale erzeugenden elektronischen Signalweg der Anlage geschaltet ist und eine Abschalteinrichtung aufweist, die zum Erkennen des Lautstärkepegels diesen aus der im Signalweg gemessenen Spannung ermittelt,
**dadurch gekennzeichnet**,
daß die Abschalteinrichtung zusätzlich über einen Signalkompressor zur Signalkompression zwischen Ein- und Ausgangssignal verfügt, und daß der Signalkompressor eine Regelung zur Einstellung der Kompressorfunktion enthält.

2. Vorrichtung nach Anspruch 1, dadurch gekennzeichnet, daß die Abschalteinrichtung eine Regelung zur Einstellung der Kompression zwischen Ein- und Ausgangssignal, eine Regelung zur Einstellung der Anstiegs- und Abfallzeit der Flanken des NF-Signals sowie eine Regelung zur Einstellung der Reaktionsschnelligkeit der Regelung zur Einstellung der Kompression aufweist.

3. Vorrichtung nach Anspruch 1 oder 2, gekennzeichnet durch eine elektronische Abschalteinrichtung, die bei extremer Pegelüberschreitung des maximal zulässigen Lautstärkepegels (NF-Pegel) das NF-Signal unterbricht und einen weiteren Betrieb der Anlage so lange verhindert, bis sich der gemessene NF-Pegel wieder im zulässigen Bereich befindet.

4. Vorrichtung nach Anspruch 3, dadurch gekennzeichnet, daß der Überschreitpegel ungefähr +3 db über dem maximal zulässigen Lautstärkepegel liegt.

5. Vorrichtung nach einem der Ansprüche 1 bis 4, gekennzeichnet durch einen Eingangsregler zum Einstellen der maximalen Eingangsempfindlichkeit der Begrenzungsvorrichtung.

6. Vorrichtung nach Anspruch 5, dadurch gekennzeichnet, daß der Spannungsregelbereich des Eingangsreglers -20 db bis +20 db beträgt.

7. Vorrichtung nach einem der Ansprüche 1 bis 6, gekennzeichnet durch einen Ausgangsregler zum Einstellen des maximalen Ausgangspegels für die maximal zulässige Lautstärke.

8. Vorrichtung nach Anspruch 7, dadurch gekennzeichnet, daß der Spannungsregelbereich des Ausgangsreglers -20 db bis +20 db beträgt.

9. Vorrichtung nach einem der Ansprüche 1 bis 8, dadurch gekennzeichnet, daß das anliegende NF-Signal durch den Regler zur Kompression in einem Bereich von 1:1 bis maximal 10:1 zwischen Ein- und Ausgang komprimierbar ist.

10. Vorrichtung nach einem der Ansprüche 2 bis 9, dadurch gekennzeichnet, daß durch den Regler zur Einstellung der Anstiegs- und Abfallzeit der Flanken des NF-Signals die Anstiegs- und Abfallzeit der Flanken des anliegenden NF-Signals sowie die optische Anzeige einer Anzeigeeinrichtung für den momentanen NF-Pegel in einem Bereich von ungefähr 20 msec bis 3 sec einstellbar ist.

11. Vorrichtung nach einem der Ansprüche 2 bis 10, dadurch gekennzeichnet, daß der Einstellbereich des Reglers zur Einstellung der Reaktionsschnelligkeit dreistufig mit den Stufen von ungefähr 0,3 msec, 3 msec, 7 msec ausgebildet ist.

12. Vorrichtung nach einem der Ansprüche 2 bis 11, dadurch gekennzeichnet, daß die Pegel bzw. Regler frei einstellbar sind.

13. Vorrichtung nach einem der Ansprüche 1 bis 12, dadurch gekennzeichnet, daß die Einstell- und Anschlußelemente der Vorrichtung in einem verschließbaren Gehäuse vor unbefugten Fremdeingriffen gesichert angeordnet sind.

## Claims

1. Apparatus for electronically disconnecting an electroacoustic system or public address system when a predetermined maximum loudness level is exceeded, which apparatus is connected into the electronic signal path, which generates the audio signals, of the system and has a disconnection device which, for the purpose of identifying the loudness level, determines the latter from the voltage measured in the signal path, characterized in that the disconnection device additionally has a signal compressor for signal compression between the input and output signals, and in that the signal compressor contains a control system for setting the compressor function.

2. Apparatus according to Claim 1, characterized in that the disconnection device has a control system for setting the compression between the input and output signals, a control system for setting the rise and fall times of the edges of the AF signal, and also a control system for setting the reaction speed of the control system for setting the compression.

3. Apparatus according to Claim 1 or 2, characterized by an electronic disconnection device which, in the event of the maximum permissible loudness level (AF level) being exceeded to an extreme degree, interrupts the AF signal and prevents further operation of the system until the measured AF level is once more in the permissible range.

4. Apparatus according to Claim 3, characterized in that the exceed level is approximately +3 dB above the maximum permissible loudness level.

5. Apparatus according to one of Claims 1 to 4, characterized by an input controller for setting the maximum input sensitivity of the limiting apparatus.

6. Apparatus according to Claim 5, characterized in that the voltage control range of the input controller is -20 dB to +20 dB.

7. Apparatus according to one of Claims 1 to 6, characterized by an output controller for setting the maximum output level for the maximum permissible loudness.

8. Apparatus according to Claim 7, characterized in that the voltage control range of the output controller is -20 dB to +20 dB.

9. Apparatus according to one of Claims 1 to 8, characterized in that the applied AF signal can be compressed by the controller for compression in a range of 1:1 to at most 10:1 between the input and the output.

10. Apparatus according to one of Claims 2 to 9, characterized in that the controller for setting the rise and fall times of the edges of the AF signal can set the rise and fall times of the edges of the applied AF signal and the optical display of a display device for the instantaneous AF level in a range of approximately 20 msec to 3 sec.

11. Apparatus according to one of Claims 2 to 10, characterized in that the setting range of the controller for setting the reaction speed is designed in three stages, with the stages of approximately 0.3 msec, 3 msec, 7 msec.

12. Apparatus according to one of Claims 2 to 11, characterized in that the levels and controllers can be set freely.

13. Apparatus according to one of Claims 1 to 12, characterized in that the setting and connection elements of the apparatus are arranged in a lockable housing in a manner secured against unauthorized external tampering.

## Revendications

1. Dispositif destiné à interrompre de manière électronique, un système électroacoustique ou une installation de sonorisation, lors du dépassement d'un niveau d'intensité sonore maximal prédéterminé, qui est inséré dans le circuit de signal électronique de l'installation, produisant les signaux audio, et qui comporte un dispositif d'interruption, qui pour relever le niveau d'intensité sonore, détermine celui-ci à partir de la tension mesurée dans le circuit du signal,
caractérisé en ce que le dispositif d'interruption dispose en supplément, d'un compresseur de signal pour assurer une compression de signal entre le signal d'entrée et le signal de sortie, et en ce que le compresseur de signal renferme une commande de réglage pour régler la fonction de compresseur.

2. Dispositif selon la revendication 1, caractérisé en ce que le dispositif d'interruption comprend une commande de réglage pour régler la compression entre le signal d'entrée et le signal de sortie, une commande de réglage pour régler le temps de montée et le temps de chute des flancs du signal d'audiofréquence, ainsi qu'une commande de réglage pour régler la vitesse de réponse de la commande de réglage pour régler la compression.

3. Dispositif selon la revendication 1 ou 2, caractérisé par un dispositif d'interruption électronique, qui lors d'un dépassement extrême de niveau du niveau d'intensité sonore maximal admissible (niveau d'audiofréquence) interrompt le signal d'audiofréquence, et empêche la poursuite du fonctionnement de l'installation jusqu'à ce que le niveau d'audiofréquence mesuré se trouve à nouveau dans la plage autorisée.

4. Dispositif selon la revendication 3, caractérisé en ce que le niveau de dépassement se situe environ à +3 dB au-dessus du niveau d'intensité sonore maximal autorisé.

5. Dispositif selon l'une des revendications 1 à 4, caractérisé par une commande de réglage d'entrée pour régler la sensibilité d'entrée maximale du dispositif de limitation.

6. Dispositif selon la revendication 5, caractérisé en ce que la plage de réglage de tension de la commande de réglage d'entrée vaut -20 dB à +20 dB.

7. Dispositif selon l'une des revendications 1 à 6, caractérisé par une commande de réglage de sortie pour régler le niveau de sortie maximal pour l'intensité sonore maximale autorisée.

8. Dispositif selon la revendication 7, caractérisé en ce que la plage de réglage de tension de la commande de réglage de sortie vaut -20 dB à +20 dB.

9. Dispositif selon la revendication 1 à 8, caractérisé en ce que le signal d'audiofréquence appliqué peut être compressé dans une plage de 1:1 jusqu'au maximum 10:1 entre l'entrée et la sortie, par la commande de réglage pour la compression.

10. Dispositif selon l'une des revendications 2 à 9, caractérisé en ce que la commande de réglage pour régler le temps de montée et le temps de chute des flancs du signal d'audiofréquence permet de régler le temps de montée et le temps de chute du signal d'audiofréquence appliqué, ainsi que l'affichage optique d'un dispositif d'affichage pour le niveau d'audiofréquence momentané, dans une plage d'environ 20 ms à 3 s.

11. Dispositif selon l'une des revendications 2 à 10, caractérisé en ce que la plage de réglage de la commande de réglage pour régler la vitesse de réponse, est à trois échelons, avec les échelons d'environ 0,3 ms, 3 ms et 7 ms.

12. Dispositif selon l'une des revendications 2 à 11, caractérisé en ce que les niveaux, à savoir les commandes de réglage sont librement réglables.

13. Dispositif selon l'une des revendications 1 à 12, caractérisé en ce que les éléments de réglage et les éléments de connexion du dispositif sont agencés dans un boîtier verrouillable, en assurant ainsi une sécurité à l'encontre d'interventions étrangères non autorisées.
